# EUROPÄISCHE PATENTANMELDUNG

(11) **EP 3 614 821 A1**
(43) Veröffentlichungstag der Anmeldung: **26.02.2020**
(21) Anmeldenummer: 18190291.7
(22) Anmeldetag: 22.08.2018
(51) Int. Cl.: H05K 13/06, H01R 43/28, H02B 3/00

(54) **VERDRAHTUNGSROBOTER UND VERFAHREN ZUM VERDRAHTEN, SYSTEM UND VERFAHREN ZUM PLANEN VON VERDRAHTUNGEN, SYSTEM UND VERFAHREN ZUM ERFASSEN VON BAUTEILEN**

(71) Anmelder: W. Althaus AG, 4912 Aarwangen (CH)
(72) Erfinder: Deprato, Davor, 4616 Kappel (CH); Chelini, Leandro Francesco, 8620 Wetzikon (CH); Althaus, Walter, 4912 Aarwangen (CH); Rotach, Toby Andreas, 8055 Zürich (CH)
(74) Vertreter: Hepp Wenger Ryffel AG

(57) **Zusammenfassung**

Die vorliegende Erfindung betrifft einen Verdrahtungsroboter (1) insbesondere zum Verdrahten von Montageplatten und Montagerahmen, von Schaltschränken und Schaltgerätekombinationen oder Teilen davon. Der Verdrahtungsroboter (1) umfasst einen Roboterkopf (4), eine Drahtzuführeinrichtung (40) für eine zu verlegende Litze (10) und einen Greifer (20) zum Halten und Applizieren der Litze (10). Die Litze (10) wird mittels der Drahtzuführeinrichtung (40) dem Greifer (20) zugeführt, wobei der Greifer (20) bewegbar im Roboterkopf (4) gehalten und zwischen einer Einsetzposition (30) und einer Umgreifposition (31) bewegbar ist. Ein Litzenende (49) der zugeführten Litze (10) ist in der Umgreifposition (31) mittels des Greifers (20) greifbar und ein Litzenanfang (48) und/oder das Litzenende (49) der zugeführten Litze (10) sind in einer Einsetzposition (30) mittels des Greifers (20) applizierbar. Dabei ragt beim Applizieren der Litzenanfang (48) oder das Litzenende (49) in der Einsetzposition (30) des Greifers (20) aus einer Applikationsseite (22) des Greifers (20) heraus.

## Beschreibung

Die vorliegende Erfindung betrifft einen Verdrahtungsroboter und ein Verfahren zum Verdrahten. Der Verdrahtungsroboter findet Anwendung z. B. beim Verdrahten von Montageplatten und Montagerahmen, von Schaltschränken und Schaltgerätekombinationen oder Teilen davon. Die Erfindung betrifft ebenfalls ein System und ein Verfahren zum Planen von Verdrahtungen und ein System und ein Verfahren zum Erfassen von Bauteilen gemäss dem Oberbegriff der unabhängigen Ansprüche.

Roboter sind aus der heutigen industriellen Produktion von Konsumgütern nicht mehr weg zu denken. Als erstes wurden einfache repetitive Arbeiten, wie das Bestücken von Maschinen oder das Entnehmen von Bauteilen automatisiert. Mit der Zeit wurden immer mehr Arbeitsschritte von Robotern übernommen, sodass heute nur noch bei sehr individualisierten Arbeiten der Mensch zum Zug kommt. Oft arbeiten kollaborative Robotersysteme bei individualisierten Arbeitsschritten Hand in Hand mit Menschen.

Zur Verdrahtung von elektrischen Bauteilen werden ebenfalls Roboter eingesetzt.

DE 297 22 494 U1 beschreibt eine Vorrichtung zum Verdrahten von Anschlussstellen von Komponenten elektrischer Geräte oder Anlagen.

DE 360 60 59 A1 beschreibt Werkzeuge zum Verlegen und Ablängen von Kabeln mit Hilfe eines Industrieroboters.

DE 443 12 54 A1 beschreibt ein Verfahren und eine Vorrichtung zur automatischen Verdrahtung von Komponenten elektrischer Geräte, z.B. von Fassungen, Vorschaltgeräten, Klemmen und dergleichen bei Leuchtstofflampen.

EP 0 917 259 B1 beschreibt ein Verfahren und eine Vorrichtung zum automatischen Verdrahten von Anschlussstellen von Komponenten elektrischer Geräte.

DE 443 85 25 A1 beschreibt ein Verfahren und eine Vorrichtung zur Bearbeitung und Verdrahtung von Schaltschränken und ihren Komponenten.

Alle in diesen Dokumenten beschriebenen Lösungen weisen die Nachteile auf, dass nur fix vorprogrammierte, standardisierte Arbeiten erledigt werden können.

DE 198 10 115 A1 beschreibt ein Verfahren zur Leitungsberechnung von Anschlussleitungen. Dabei wird mittels einer Kamera ein Schaltschrankbild erstellt und der Bediener erstellt am Computer eine virtuelle Verkabelung. Eine Kabelkonfektionierungsmaschine schneidet dann die entsprechenden Kabel zu.

DE 195 12 840 A1 beschreibt ein Verfahren und eine Einrichtung für die Montage und Verdrahtung eines Schaltschrankes. Dabei werden durch zwei optische Zeigeeinheiten die zu verbindenden Komponenten im Schaltschrank markiert, um dem Arbeiter ein zeitaufwendiges Suchen zu ersparen. Ähnlich funktioniert die Einrichtung für den Zusammenbau und die Verdrahtung eines Schalt-/Verteilerschrankes gemäss DE 203 01 637 U1. Hierbei werden ebenfalls Zeigeeinrichtungen verwendet, um die Position des nächsten Bauteils das eingebaut werden soll zu markieren.

Die zuletzt beschriebenen Vorrichtungen haben die Nachteile, dass sie nur einen bestimmen Schritt des Verdrahtungsprozesses übernehmen und die Hauptlast der Arbeit immer noch beim Bediener liegt. Zusätzlich haben die beschriebenen Lösungen die Nachteile, dass die Konstruktion ihrer Greifer eine Verdrahtung von eng nebeneinander liegenden Anschlussstellen nicht zulässt oder beim Anschliessen ebensolcher die Gefahr besteht, dass schon vorhandene Verdrahtungen beschädigt oder gelöst werden.

Andererseits gibt es komplexe Roboter, welche eine komplette Verkabelung eines Schaltschrankes erledigen, jedoch auf Grund ihrer Komplexität Fehler anfällig sind und in Herstellung und Betrieb komplex sind (Averex,
https://www.youtube.com/watch?v=Xg5ppssm00M).

DE 297 22 494 U1 zeigt einen Greifer, welcher einen Litzenanfang in einer Einsetzposition einsetzt. Anschliessend wird eine Litze verlegt, wobei ein Litzenende schlussendlich zu einer Litzenzufuhr zeigt, wenn es den Greifer erreicht. Der Greifer schwenkt das Litzenende in die Einsetzposition und schliesst das Litzenende an. Der Greifer ist hierbei so ausgebildet, dass sich eine Greiferschwenkachse mittig im Greifer befindet. Diese Konstruktion birgt den Nachteil, dass der Greifer breit ausgebildet ist, da der Rotationsmechanismus auf Höhe der Applikationsseite angebracht werden muss. Ein breiter Greifer kann zu Problemen führen, beim Verdrahten von eng nebeneinanderliegenden Anschlussstellen, da bestehende Verdrahtungen im Weg sind.

DE 443 12 54 A1 zeigt einen Greifer, welcher eine Litze verlegt, wobei ein Litzenanfang und ein Litzenende in einer Einsetzposition sich senkrecht zu einem Kabelpfad befinden. Der Greifer ist schmal ausgebildet und muss nicht zwingend rotieren, um das Litzenende anzuschliessen. Diese Bauweise birgt den Nachteil, dass ein Bauteil mit einer Anschlussstelle, welche sich senkrecht zu einer Montageplatte befindet, aus Platzgründen nicht oder nur erschwert angeschlossen werden kann.

Es ist daher Aufgabe der Erfindung, die Nachteile im Stand der Technik zu beheben. Insbesondere soll ein Verdrahtungsroboter bereitgestellt werden, welcher eine Verdrahtung von eng nebeneinander liegenden Anschlussstellen ermöglicht. Ausserdem soll ein Verdrahtungsroboter bereitgestellt werden, welcher einfach im Aufbau ist und zuverlässig arbeitet und ein Verdrahtungsroboter welcher eine Litze auf einfache Weise aufnehmen kann. Ergänzend soll ein System zum Planen von Verdrahtungen und ein System zum Vermessen von Bauteilen bereitgestellt werden. Beide Systeme unterstützen ein effizientes Arbeiten der Verdrahtungsroboter. Abschliessend sollen Verfahren zur Verdrahtung mit den Verdrahtungsrobotern, ein Verfahren zum Planen von Verdrahtungen und ein Verfahren zum Erfassen von Bauteilen bereitgestellt werden.

Erfindungsgemäss werden diese und andere Aufgaben mit den Merkmalen gemäss dem kennzeichnenden Teil der unabhängigen Patenansprüche gelöst.

Ein erfindungsgemässer Verdrahtungsroboter, insbesondere zum Verdrahten von Montageplatten und Montagerahmen, von Schaltschränken und Schaltgerätekombinationen oder Teilen davon umfasst einen Roboterkopf, eine Drahtzuführeinrichtung für einen zu verlegenden Leiter, insbesondere eine Litze und einen Greifer zum Halten und Applizieren der Litze. Die vorliegende Erfindung eignet sich zum Verlegen von Leitern aller Art. Sie wird nachstehend unter Bezugnahme auf Litzen erläutert, ohne dass dies als Beschränkung auf Litzen zu verstehen ist. Die Litze wird dabei von der Drahtzuführeinrichtung dem Greifer entlang eines Litzenpfades zugeführt. Der Greifer ist bewegbar im oder am Roboterkopf montiert und kann mindestens eine Einsetzposition und eine Umgreifposition einnehmen. Der Anfang einer zu verlegenden Litze wird in der Einsetzposition vom Greifer gehalten. Das Ende einer zu verlegenden Litze kann vom Greifer ergriffen werden, wenn dieser in der Umgreifposition ist. Der Litzenanfang und/oder das Litzenende sind an einer gewünschten Stelle applizierbar, wenn der Greifer sich in der Einsetzposition befindet. In der Einsetzposition ragt der Litzenanfang oder das Litzenende jeweils aus einer Applikationsseite des Greifers heraus beim Applizieren. Die Applikationsseite ist für den Litzenanfang und das Litzenende gleich.

Der Greifer ist bevorzugt schwenkbar um eine Greiferschwenkachse ausgebildet, insbesondere um eine Greiferschwenkachse, welche senkrecht zum Litzenpfad steht. Die Applikationsseite ist dabei bevorzugt von der Drahtzuführeirichtung abgewandt, wenn sich der Greifer in der Einsetzposition befindet und der Drahtzuführeirichtung zugewandt, wenn sich der Greifer in der Umgreifposition befindet. Ein Vorteil einer solchen einfachen Bauweise ist, dass der Greifer schmal konstruiert werden kann.
Der Greifer des erfindungsgemässen Verdrahtungsroboters rotiert bevorzugt um 180° um die Greiferschwenkachse, wenn er sich von der Umgreif- in die Einsetzposition oder umgekehrt bewegt.

Der Greifer des erfindungsgemässen Verdrahtungsroboters weist bevorzugt einen Greifer mit mindestens zwei Greifbacken auf, welche insbesondere ein winkliges Klemmprofil aufweisen. Das winklige Klemmprofil ermöglicht es, Litzen mit unterschiedlichen Durchmessern zu greifen. Das winklige Klemmprofil weist bevorzugt einen Winkel zwischen 60 und 120°, besonders bevorzugt zwischen 70 und 110° und ganz besonders bevorzugt zwischen 80 und 100° auf.

Die Drahtzuführeinrichtung ist bevorzugt so ausgebildet, dass die Litze in beide Richtungen transportiert werden kann, also zum Greifer hin oder von diesem weg entlang des Litzenpfades.

Bevorzugt hat der Verdrahtungsroboter einen Haltemechanismus, um eine Litze zu halten. Der Haltemechanismus wird bevorzugt durch eine Haltemechanismussteuerung gesteuert. Der Verdrahtungsroboter weist ebenfalls bevorzugt eine Greifersteuerung auf, um den Greifer zu steuern.

Die Haltemechanismussteuerung ist dabei bevorzugt so ausgebildet, dass der Haltemechanismus die Litze hält, wenn der Greifer geöffnet ist und die Litze nicht hält oder klemmt, wenn der Greifer geschlossen ist. Die Greifersteuerung ist so ausgebildet, dass sie den Greifer öffnet, bevor sich der Greifer von der Einsetz- in die Umgreifposition bewegt und dass sie den Greifer in der Umgreifposition wieder schliesst und geschlossen bleibt wenn der Greifer in die Einsetzposition zurück schwenkt. Die Zusammenarbeit des Haltemechanismus und der Greifersteuerung ermöglichen es dem Greifer die Litze umzugreifen, während die Litze durch den Haltemechanismus gehalten wird.

Der Haltemechanismus des erfindungsgemässen Verdrahtungsroboters weist bevorzugt Rollen zum Festhalten, Führen und Fördern des Kabels auf. Diese Rollen können in der Drahtzuführeinrichtung integriert sein. Die Rollen können eine Litze halten und fördern und bevorzugt in einem geöffneten Zustand die Litze freigeben.

Das Klemmprofil der Greifbacken des Greifers des erfindungsgemässen Verdrahtungsroboters weist bevorzugt eine Länge von 5.0 - 20.0 mm und besonders bevorzugt eine Länge von 7.0 - 12.0 mm auf. Das Klemmprofil kann Litzen mit einem Aussendurchmesser von 0.5 - 10 mm, bevorzugt mit einem Aussendurchmesser von 1 - 6 mm und besonders bevorzugt mit einem Aussendurchmesser von 2 - 4 mm klemmen. Alternativ oder ergänzend dazu weist die Applikationsseite des Greifers des erfindungsgemässen Verdrahtungsroboters eine bevorzugte Grundfläche von weniger als 50 mm², besonders bevorzugt weniger als 35 mm² und ganz besonders bevorzugt von weniger als 25 mm² auf. Eine Mantelfläche des Greifers befindet sich bevorzugt innerhalb eines gedachten Konus mit einem Winkel gegenüber einer Längsachse von 20°, bevorzugt 15° und besonders bevorzugt 10°. Durch den flachen Winkel der Mantelfläche und den geringen Durchmesser der Applikationsfläche erhält der Greifer eine schmale und spitze Form, welche es ihm ermöglicht, eng nebeneinander liegende Anschlussstellen zu verdrahten.

Ein weiterer Aspekt der Erfindung betrifft einen Verdrahtungsroboter, welcher einen Roboterkopf, eine Drahtzuführeinrichtung für eine zu verlegende Litze und einen Greifer zum Halten und Applizieren der Litze umfasst. Der Verdrahtungsroboter ist so gestaltet, dass Litzen direkt und insbesondere durch eine Applikationsseite mit einem Greifer greifbar und mit einer Drahtzuführeinrichtung einziehbar sind. Der Greifer ist bevorzugt derart ausgebildet, dass er die Litze aus einer Lagereinheit oder einem anderen Behältnis oder von einer Fläche aufnehmen kann. Die Drahtzuführeinrichtung ist bevorzugt derart ausgebildet, dass sie die Litze vom Greifer übernimmt und diese einzieht. Eine komplizierte, externe Zuführung der Litze zum Greifer entfällt, da die Litze direkt aufgenommen und anschliessend verlegt wird. Eine Kombination mit den vorstehenden Aspekten ist denkbar aber nicht zwingend.

Ein weiterer Aspekt der Erfindung betrifft einen Verdrahtungsroboter, welcher einen Roboterkopf, eine Drahtzuführeinrichtung für eine zu verlegende Litze und einen Greifer zum Halten und Applizieren der Litze umfasst. Der Verdrahtungsroboter ist kollaborativ ausgebildet. Eine Kombination mit den vorstehenden Ansprüchen ist denkbar aber nicht zwingend.

Ein kollaborativer Roboter erlaubt eine sequenzielle oder parallele Kooperation zwischen Mensch und Roboter. Bei der sequenziellen Kooperation muss der Roboter bei Personenzutritt in den Arbeitsraum einen sicherheitsbewerteten überwachten Halt einlegen. Dabei wird der Roboter gestoppt, sobald sich etwas in seinem Arbeitsbereich befindet. Der Roboter kann anschliessend automatisch weiterarbeiten, wenn die Person oder das Objekt den Arbeitsbereich verlässt oder daraus entfernt wird. Bei der parallelen Kooperation weist der Roboter eine Geschwindigkeits- und Abstandsüberwachung auf. Dabei wird die Geschwindigkeit des Roboters beim Annähern einer Person reduziert und falls ein Sicherheitsabstand unterschritten wird, wird der Roboter sicher angehalten. Eine weitere Variante eines kollaborativen Roboters wäre ein Roboter mit Kraft beziehungsweise Druckbegrenzung. Diese Variante kann mit den anderen Formen der Mensch-Roboter Kooperation, wie sequenzieller oder paralleler Kooperation, kombiniert werden.

Der Vorteil eines kollaborativen Verdrahtungsroboters ist, dass der Benutzer die Arbeit überwachen kann und gegebenenfalls eingreift, falls ein Bauteil falsch, ungenügend genau oder unpässlich verdrahtet wird. Zusätzlich kann der Benutzer auch komplexere Arbeiten erledigen, welche vom Verdrahtungsroboter selbst nicht übernommen werden können, wie z.B. das Verdrahten bzw. Anschliessen von Schraubklemmen. Der Greifer kann dabei das Ende einer Litze in unmittelbarer Nähe der Komponente oder deren Anschlussstelle platzieren und mit einem integrierten Zeigesystem, vorzugsweise einem Laser, auf die Anschlussposition zeigen.

Ein weiter Aspekt der Erfindung betrifft ein System zum Planen von Verdrahtungen, insbesondere zum Verdrahten von Montageplatten und Montagerahmen, von Schaltschränken und Schaltgerätekombinationen oder Teilen davon. Das System umfasst eine Messeinheit zum Erfassen der Art und Position von elektrischen Komponenten, eine Rechneranordnung zur Verarbeitung der Messresultate der Messeinheit und eine Eingabevorrichtung zur Eingabe von Verdrahtungsinformationen.

Die Rechneranordnung des erfindungsgemässen Systems zum Planen von Verdrahtungen ist so ausgebildet, dass sie auf Basis der Verdrahtungsinformation und mittels der von der Messeinheit bestimmten Position und Art der Bauteile eine Position der Komponente und Anschlussstellen kontrolliert und gegebenenfalls rechnerisch korrigiert.

Die Messeinheit des Systems zum Planen von Verdrahtungen ist bevorzugt z.B. an einem Werkzeugflansch eines Verdrahtungsroboters oder direkt an einem Greifer eines Verdrahtungsroboters angebracht. Die Messeinheit umfasst bevorzugt einen Laserdistanzsensor und eine Kamera. Zum Erfassen von elektrischen Komponenten wird der Laserdistanzsensor bevorzugt entlang einer Tragschiene bewegt und misst kontinuierlich die Distanz. Sobald die Distanz einen Distanzschwellwert unterschreitet oder überschreitet, wird eine Kante der Komponente detektiert. Aufgrund dieser Kantenerkennung wird die Kamera grob auf die detektierte Komponente ausgerichtet. Ein Vision-System vergleicht ein Kamerabild mit einem Referenzbild einer erwarteten Komponente und ermittelt daraus eine korrekte Komponentenposition in einer Bildebene. Anschliessend wird der Laserdistanzsensor über der Komponente positioniert. Die gemessene Distanz wird verwendet, um die vertikale Position der Komponente zu erfassen. Die gesammelten Korrekturdaten ergänzen die Daten der geplanten Konstruktion und erlauben somit eine präzise Verkabelung.

Noch ein weiterer Aspekt der Erfindung betrifft ein System zum Erfassen von Bauteilen, insbesondere zum Erfassen von elektrischen Bauteilen. Das System umfasst eine Speicheranordnung zur Speicherung von Informationen über ein Bauteil und eine Erfassungseinheit zum Erfassen der Form und Ausmasse des Bauteils. Die Erfassungseinheit ist so ausgebildet, dass ein Messkörper, welcher in eine Anschlussstelle eines elektrischen Bauteils eingesetzt wird, erfassbar ist. Mittels der Speichereinheit ist die Anschlussstelle und insbesondere eine Position, eine Richtung und eine Einschubtiefe bestimmbar. Das System zum Erfassen von Bauteilen umfasst bevorzugt einen Drehtisch zum Rotieren des elektrischen Bauteils. Die Erfassungseinheit eines erfindungsgemässen Systems zum Erfassen von Bauteilen umfasst bevorzugt eine Kamera und einen Laser, wobei die Erfassungseinheit das Bauteil bevorzugt mit einem Lichtschnittverfahren erfassbar macht. Der Messkörper umfasst z.B. eine stabförmige Einsetzvorrichtung und eine darauf angebrachte tellerförmige Fläche. Das System zum Erfassen von Bauteilen kann als Vorstufe für die vorhergehenden Aspekte eingesetzt werden.

Ein weiterer Aspekt der Erfindung betrifft ein Verfahren zum Verdrahten von Montageplatten und Montagerahmen, von Schaltschränken und Schaltgerätekombinationen oder Teilen davon. Dabei wird ein Verdrahtungsroboter mit einem Greifer und einer Drahtzuführeinrichtung verwendet, insbesondere ein Verdrahtungsroboter wie vorstehend beschrieben. Dabei wird der Anfang einer Litze mit dem Greifer in eine erste Anschlussstelle eines ersten Bauteils eingesetzt. Der Greifer befindet sich beim Einsetzen in einer Einsetzposition. Die zu verlegende Litze wird mit dem Verdrahtungsroboter gemäss einem geplanten Litzenverlauf zu einer zweiten weiteren Anschlussstelle eines zweiten weiteren Bauteils verlegt. Selbstverständlich kann eine Litze auch zwischen zwei verschiedenen Anschlussstellen des gleichen Bauteils verlegt werden. Zum Anschliessen des Endes der Litze in die Anschlussstelle des zweiten Bauteils wird die Litze mit einem Haltemechanismus temporär gehalten. Der Greifer wird geöffnet und bewegt sich von der Einsetzposition in eine Umgreifposition, wobei eine Applikationsseite des Greifers nun zu einem Ende der Litze zeigt. Der Greifer wird danach geschlossen, um das Litzenende zu greifen. Anschliessend wird der Haltemechanismus geöffnet. Der Greifer schwenkt von der Umgreifposition in die Einsetzposition und verdrahtet mit dem hervorstehenden Litzenende die zweite Anschlussstelle des zweiten Bauteils. Das Litzenende kann während dem Umschwenken von der Umgreif- in die Einsetzposition aus dem Greifer herausragen. Falls dies nicht der Fall ist, wird das Litzenende vorgeschoben, bevor die Anschlussstelle verdrahtet wird, sodass das Litzenende aus der Applikationsseite des Greifers herausragt, wenn der Greifer in der Einsetzposition ist.

Das Anbringen von Führungseinheiten zwischen den Greifbacken ermöglicht die sichere Verlegung bzw. Platzierung der Litzen in einen Kamm eines Kabelkanals und gewährleistet einen definierten Biegeradius der Litzen nach dem Wendevorgang.

Eine im Greifer integrierte Greifersteuerung ermöglicht ein automatisches Wechseln der Greifereinheit während des Prozesses. Es können so auch applikationsspezifische Versionen von Greifern für besonders anspruchsvolle Prozesse eingesetzt und im Verdrahtungsablauf gewechselt werden.

Ein weiterer Aspekt der Erfindung betrifft ein Verfahren zum Verdrahten von Montageplatten und Montagerahmen, von Schaltschränken und Schaltgerätekombinationen oder Teilen davon unter Verwendung eines kollaborativen Verdrahtungsroboters. Dabei wird ein Arbeitsbereich des Verdrahtungsroboters mittels einer Sensorik überwacht. Falls ein Objekt in den überwachten Arbeitsbereich des Verdrahtungsroboters eindringt, wird es von der Sensorik detektiert und der Verdrahtungsroboter verlangsamt seine Arbeitsgeschwindigkeit, um einen Zusammenstoss mit dem Objekt zu vermeiden. Falls das Verlangsamen der Arbeitsgeschwindigkeit nicht ausreicht, um den Zusammenstoss zu verhindern, wird die Bewegung des Verdrahtungsroboters gestoppt.

Ein weiterer Aspekt der Erfindung betrifft ein Verfahren zum Verdrahten von Montageplatten und Montagerahmen von Schaltschränken und Schaltgerätekombinationen oder Teilen davon unter Verwendung eines Verdrahtungsroboters. Das Verfahren umfasst den Arbeitsschritt des Aufnehmens einer ausserhalb einer Drahtzufuhreinheit liegenden Litze. Dabei wird ein erstes Ende einer liegenden Litze oder einer Litze, welche sich in einer Lagereinheit befindet, mit einem Greifer erfasst, der sich in einer Einsetzposition befindet. Die Drahtzuführeinrichtung zieht die Litze ein, bis nur noch ein zweites Ende aus der Applikationsseite des Greifers herausragt. Das zweite Ende wird nun direkt appliziert, während sich der Greifer in der Einsetzposition befindet.

Es ist vorstellbar, dass der Verdrahtungsroboter jede Litze einzeln aufnimmt, bevor er diese verlegt bzw. verbaut. Dabei können die Litzen von einer separaten Einheit auf die entsprechende Länge zugeschnitten werden und der Verdrahtungsroboter erkennt anhand eines ID-Codes auf der Litze, für welche Verbindung diese Litze geplant ist. Somit würde eine in den Verdrahtungsroboter integrierte Zuschnitteinheit, welche notwendig ist, falls der Verdrahtungsroboter mit einer Endloslitze bestückt wird, überflüssig. Es ist aber ebenfalls denkbar, dass der Greifer genutzt wird, um kleinere für die manuelle Bedienung gedachte Ablängmaschienen, sowie Konfektionierungsmaschinen zu bedienen.

Ein weiterer Aspekt der Erfindung betrifft ein Verfahren zum Verdrahten von Montageplatten und Montagerahmen, von Schaltschränken und Schaltgerätekombinationen oder Teilen davon unter der Verwendung eines Verdrahtungsroboters und eines Systems zum Planen. Bauteile auf einer Montageplatte oder einem Montagerahmen werden erfasst mittels einer Messeinheit. Die Lage und Art der Bauteile wird mit einer geplanten Konstruktion mittels des Systems zum Planen, verglichen. Somit kann verhindert werden, dass eine falsch gebaute bzw. falsch bestückte Montageplatte oder Montagerahmen oder ein falsch hergestelltes Teil davon verdrahtet wird. Eine Verdrahtungsanweisung wird vom System zur Planung an den Verdrahtungsroboter geschickt, woraufhin der Verdrahtungsroboter die Bauteile, wie vorherstehend beschrieben, verdrahtet.

Ein weiterer Aspekt der Erfindung betrifft ein Verfahren zum Vermessen eines Bauteils zur Planung einer Verdrahtung, insbesondere zur Verdrahtung einer Montageplatte oder Montagerahmens eines Schaltschranks oder einer Schaltgerätekombination oder eines Teils davon. Dazu wird ein Messkörper in das Bauteil eingesetzt. Der Messkörper markiert eine Anschlussstelle zur Verdrahtung und definiert Position, Richtung und Einschubtiefe der Anschlussstelle in das Bauteil. Anschliessend wird das Bauteil und der darin eingesetzte Messkörper von einer Erfassungseinheit erfasst. Dabei wird das Bauteil bevorzugt auf einem Drehtisch platziert und mittels der fix installierten Erfassungseinheit erfasst, während der Drehtisch rotiert. Bevorzugt kann auch eine drehbare Erfassungseinheit um ein fixiertes Bauteil gedreht werden um dieses zu erfassen. Die Position, Richtung und Einschubtiefe der Anschlussstelle für ein Bauteil werden mit Hilfe einer Speicheranordnung zur Positionsbestimmung bestimmt. Charakteristische geometrische Werte des Bauteils sowie die Position, Richtung und Einschubtiefe der Anschlussstelle werden zur späteren Verwendung gespeichert.

Die Erfindung wird nachstehend anhand von Ausführungsbeispielen und Zeichnungen zum besseren Verständnis erläutert.

Es zeigen:
- Fig. 1a:: Eine perspektivische Ansicht eines Greifers eines erfindungsgemässen Verdrahtungsroboters in einer Einsetzposition.
- Fig. 1b:: Eine perspektivische Ansicht des Greifers des erfindungsgemässen Verdrahtungsroboters in einer Umgreifposition.
- Fig. 1c:: Einen Seitenansicht des Greifers des erfindungsgemässen Verdrahtungsroboters mit vergrösserter Detailansicht.
- Fig. 2a:: Einen Seitenansicht des Greifers mit einer Litze in einer Einsetzposition.
- Fig. 2b:: Eine Seitenansicht des Greifers mit der Litze in einer Umgreifposition.
- Fig. 2c:: Eine Seitenansicht des Greifers mit der Litze in der Einsetzposition.
- Fig. 3a:: Eine Draufsicht auf den Greifer in der Einsetzposition und eine Drahtzuführeinrichtung.
- Fig. 3b:: Eine Draufsicht auf den Greifer in der Umgreifposition und die Drahtzuführeinrichtung.
- Fig. 3c:: Eine Seitenansicht des Greifers und der Litzezuführeinrichtung.
- Fig. 3d:: Eine Draufsicht auf den Greifer und die Litzezuführeinrichtung.
- Fig. 4a:: Eine perspektivische Ansicht durch die Greiferbacken.
- Fig. 4b:: Eine perspektivische Ansicht und ein Querschnitt durch die Greiferbacken.
- Fig. 4c:: Ein Querschnitt durch die Greiferbacken.
- Fig. 5:: Eine schematische Darstellung eines Systems zum Planen von Verdrahtungen.
- Fig. 6a:: Eine schematische Darstellung eines Systems zum Erfassen von Bauteilen.
- Fig. 6b:: Eine perspektivische Ansicht eines Bauteils und eines Messkörpers.
- Fig. 7a-d:: Eine schematische Darstellung eines Verdrahtungsvorgangs.

Die Erfindung umfasst einen mehrachsigen und mehrgelenkigen Roboterarm eines Verdrahtungsroboters. An einem Ende des Verkabelungsroboters befindet sich ein Roboterkopf. Der Roboterkopf ist bevorzugt mit verschiedenen Werkzeugen wie Sensoreinheiten und einem Greifer ausgestattet. Mit diesen Werkzeugen kann der Verdrahtungsroboter Bauteile miteinander verdrahten.

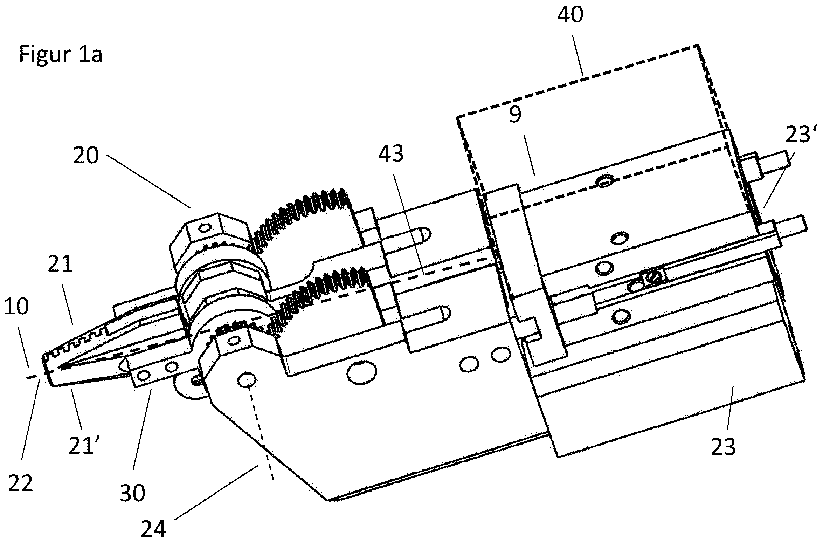

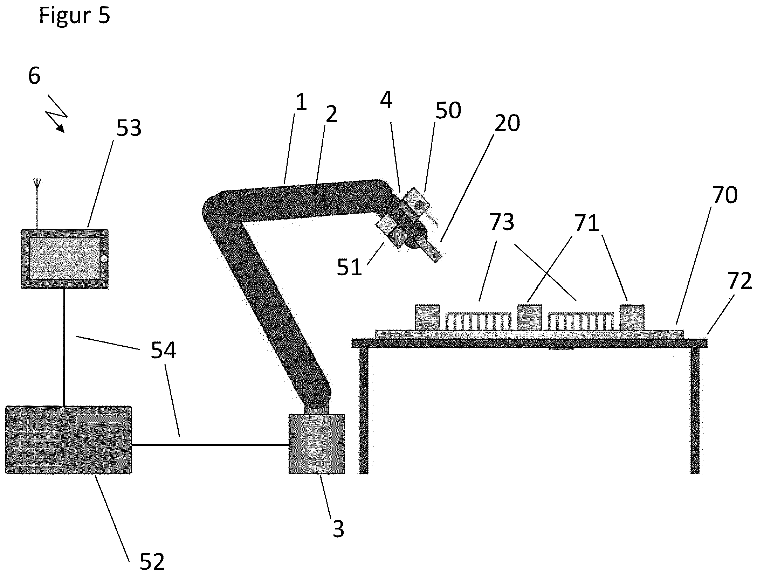

Figur 1a zeigt einen Greifer 20 eines erfindungsgemässen Verdrahtungsroboters 1 (dargestellt in Figur 5). Der Greifer 20 umfasst zwei Greifbacken 21, 21' mit einer Applikationsseite 22. Die beiden Greifbacken sind schwenkbar um eine Greiferschwenkachse 24 und werden einzeln vorzugsweise pneumatisch oder elektrisch angetrieben und positions- und / oder kraftgeregelt gesteuert mittels Drehbewegungs-Aktoren 23, 23'. Der Greifer in Figur 1a befindet sich in einer Einsetzposition 30. Ein Greifer-Aktor 9 öffnet und schliesst bzw. klemmt die Greiferbacken 21, 21'. Der Greifer-Aktor 9 ist ebenfalls vorzugsweise pneumatisch oder elektrisch angetrieben und positions- und / oder kraftgeregelt. Eine Drahtzuführeinrichtung 40 ist gestrichelt dargestellt. In der Einsetzposition 30 zeigt die Applikationsseite 22 von der Drahtzuführeinrichtung 40 weg. Von der Drahtzuführeinrichtung 40 führt eine Litze 10 durch den Greifer 20 zur Applikationsseite 22. Die Litze 10 ist gestrichelt dargestellt, um ihren Verlauf anzuzeigen. Die Litze 10 wird entlang eines Litzenpfades 43 geführt, welcher von der Drahtzuführeinrichtung 40 zum Greifer 20 führt.

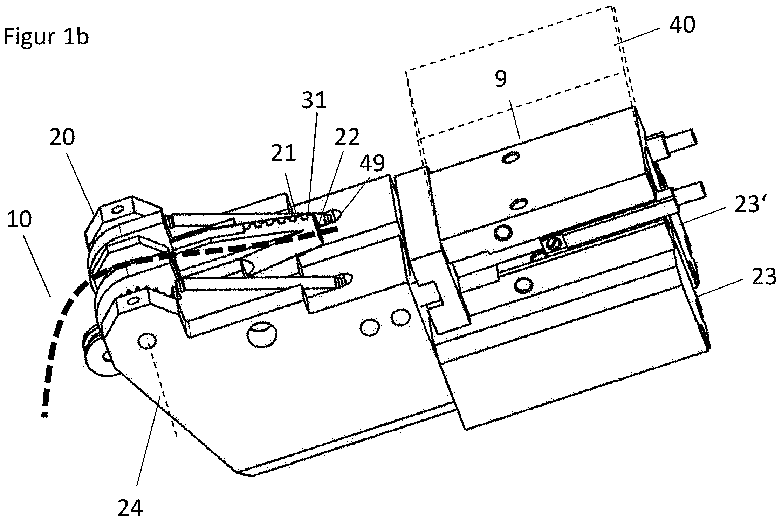

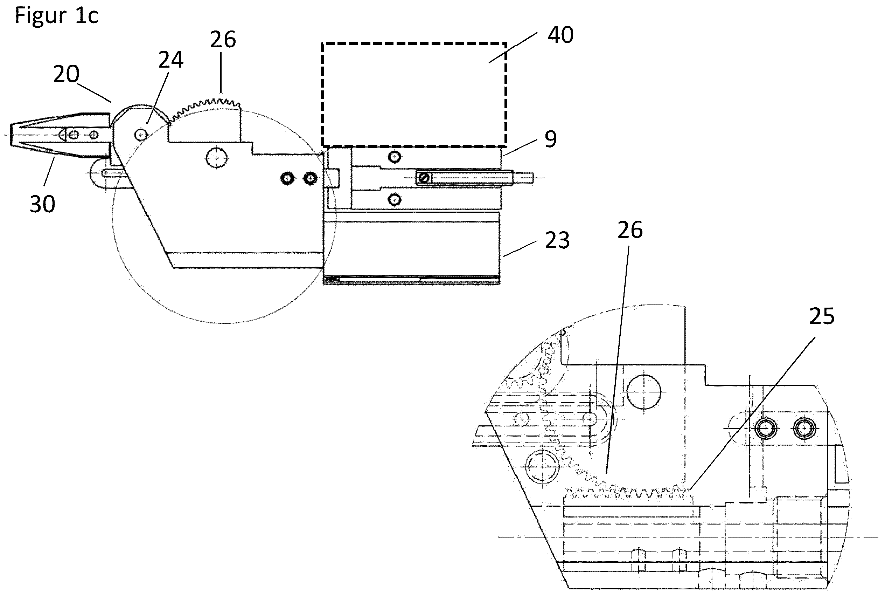

Figur 1b zeigt den Greifer 20 des erfindungsgemässen Verdrahtungsroboters 1 (dargestellt in Figur 5). Im Vergleich zu Figur 1a wurde der Greifer 20 um die Greiferschwenkachse 24 gewendet. Der Greifer 20 befindet sich in einer Umgreifposition 31, wobei die Applikationsseite 22 zur Drahtzuführeinrichtung 40 zeigt. Ein Litzenende 49 einer Litze 10 ragt aus der Applikationsseite 22 des Greifers 20 heraus. Figur 1c zeigt eine Seitenansicht des Greifers 20 des erfindungsgemässen Verdrahtungsroboters (dargestellt in Figur 5). Der Greifer befindet sich in der Einsetzposition 30. Mittels einer Zahnstange 25 und eines Zahnrades 26 kann der Greifer 20 um die Greiferschwenkachse 24 gedreht werden. Der Drehbewegungs-Aktor 23 zieht die Zahnstange 25 zurück, wobei das Zahnrad im Gegenuhrzeigersinn gedreht wird und der Greifer 20 im Uhrzeigersinn um die Greiferschwenkachse 24 von der Einsetzposition 30 in die Umgreifposition 31 schwenkt (siehe Figur 1b).

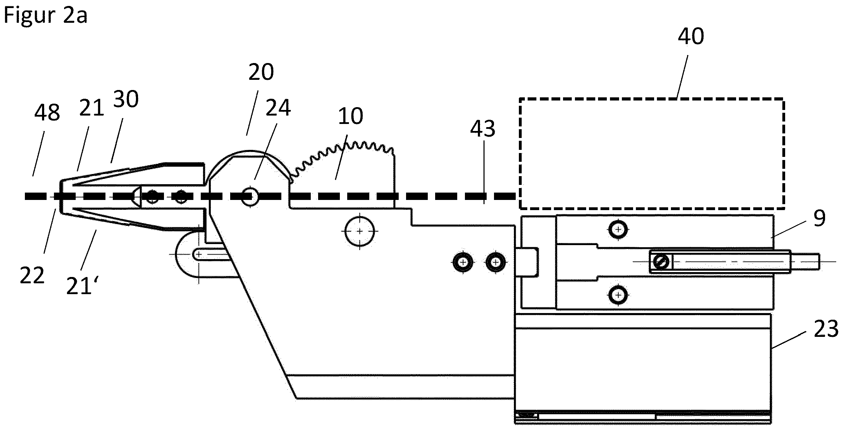

Figur 2a zeigt einen Längsschnitt durch den Greifer 20 in der Einsetzposition 30 mit einer Litze 10. Die Litze 10 umfasst ein Litzenanfang 48, welcher aus der Applikationsseite 22 des Greifers 20 herausragt. Die Litze 10 wird dabei dem Greifer 20 entlang eines Litzenpfades 43 von einer Drahtzuführeinheit 40 zugeführt. Die Litze 10 verläuft dabei durch die Greiferschwenkachse 24 zur Applikationsseite 22 des Greifers 20.

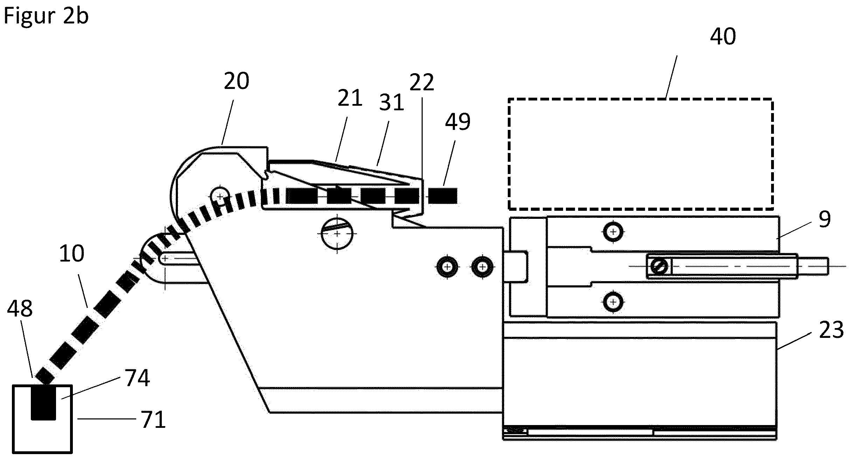

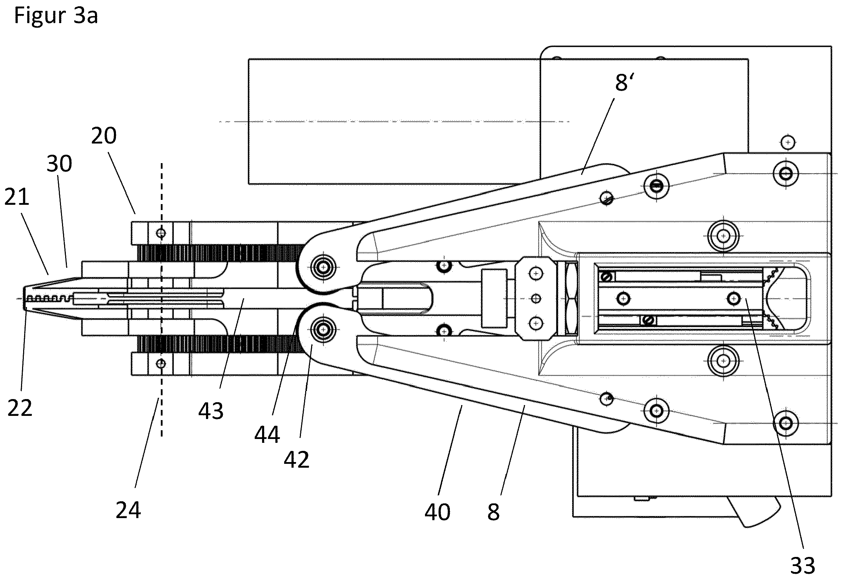

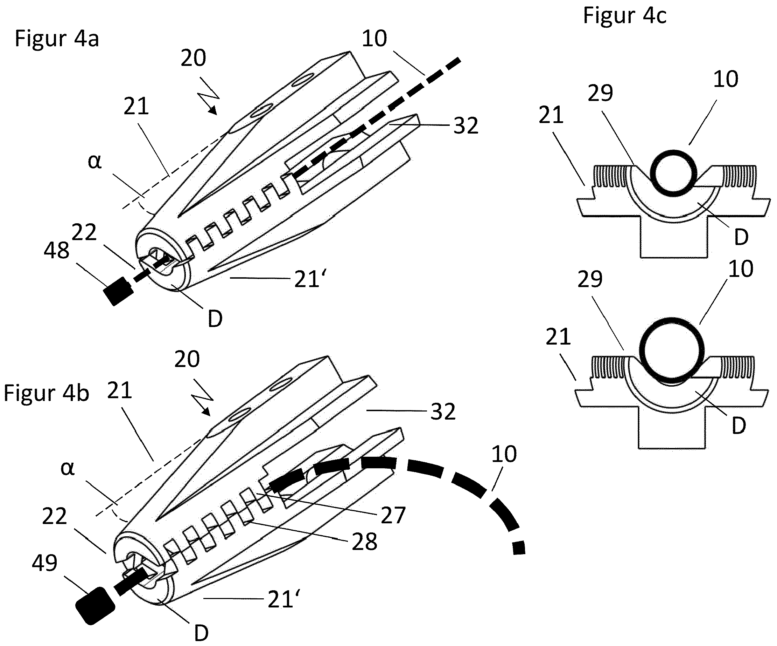

Figur 2b zeigt eine Seitenansicht des Greifers 20 in der Umgreifposition 31 mit der Litze 10. Beim Umgreifen wird erst die Litze 10 mit einem Haltemechanismus 42 (Figur 3a) geklemmt. Anschliessend öffnet sich der Greifer und schwenkt von der Einsetzposition 30 in die Umgreifposition 31, wo das Litzenende 49 wieder geklemmt wird. Das Litzenende 49 der Litze 10 ragt dabei nun aus der Applikationsseite 22 heraus und zeigt zur Drahtzuführeinheit 40. Der Kabelanfang 48 ist in einer Anschlussstelle 74 eines Bauteils 71 verbaut. Das gebogene Stück der Litze 10 wird dabei nach dem Herumschwenken in die Umgreifposition senkrecht zwischen den Greiferbacken 21, 21' durch eine Öffnung 32 (Figur 4) geführt.

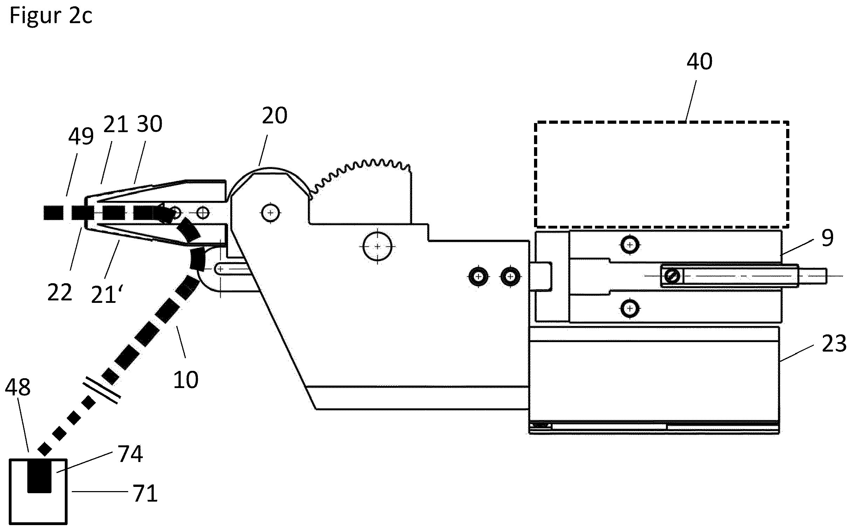

Figur 2c zeigt eine Seitenansicht des Greifers 20 in der Einsetzposition 30 mit einer Litze 10. Im Vergleich zu Figur 2b wurde der Greifer 20 um die Greiferschwenkachse 24 geschwenkt und das Litzenende 49 zeigt nun von der Drahtzuführeinheit 40 weg. Vor dem Schwenken des Greifers wurde der Haltemechanismus 42 (Figur 3a) gelöst, um die Litze 10 freizugeben. Das Litzenende 49, welches aus der Applikationsseite 22 des Greifers 20 herausragt, kann nun an eine Anschlussstelle eines weiteren Bauteils (nicht dargestellt) angeschlossen werden.

Figur 3a zeigt eine Draufsicht auf den Greifer 20 und die Drahtzuführeinrichtung 40. Die Greifbacken 21 sind in der Einsetzposition 30, wobei die Applikationsseite 22 von der Drahtzuführeinrichtung 40 weg zeigt. In der dargestellten Ausführungsform befindet sich ein Haltemechanismus 42 in Förderrichtung am Ende der Drahtzuführeinrichtung 40 und ist geschlossen. Der Haltemechanismus 42 umfasst einen Antrieb 33, Wippen 8 und 8' sowie Rollen 44, welche benutzt werden, um die Litze 10 (nicht dargestellt) zu fördern und wahlweise zu fixieren. Dabei klemmen die Rollen 44 die Litze 10 (nicht dargestellt), welche sich im Litzenpfad 43 befindet.

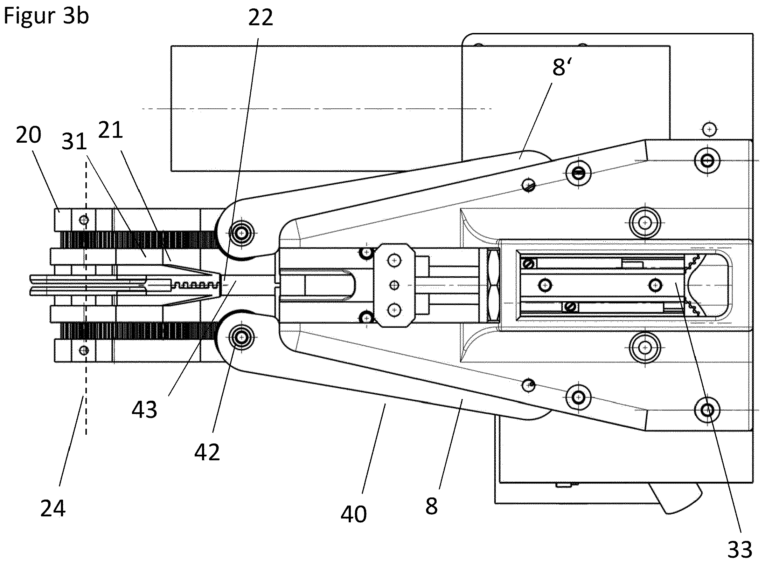

Figur 3b zeigt eine Draufsicht auf den Greifer 20 in der Umgreifposition 31 und die Drahtzuführeinrichtung 40 bevor der Greifer 20 wieder umschwenkt in die Einsetzposition 30 (Figur 3a). Der Haltemechanismus 42 an der Spitze der Drahtzuführeinrichtung 40 ist geöffnet und die Greiferbacken 21 sind geschlossen. In der Umgreifposition zeigt die Applikationsseite 22 zum Haltemechanismus 42.

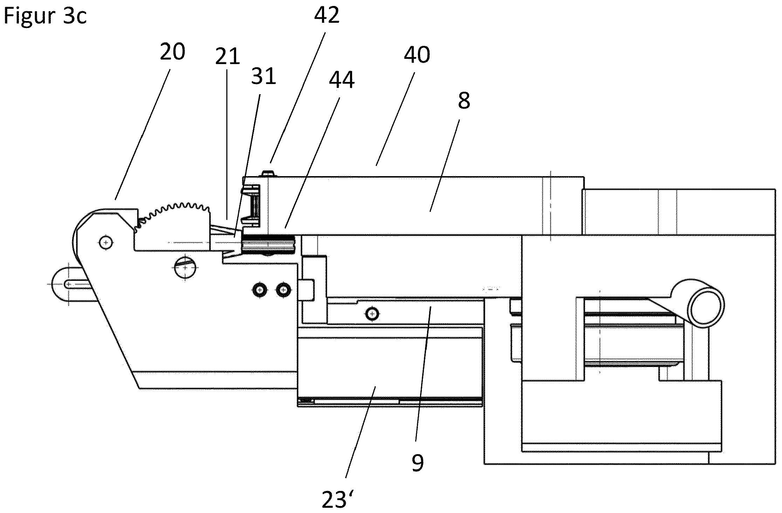

Figur 3c zeigt eine Seitenansicht des Greifers 20 und der Drahtzuführeinrichtung 40. Die Rollen 44 des Haltemechanismus 42 befinden sich zu beiden Seiten des Litzenpfades 43 (Figur 3b) in einer Ebene mit den Greifbacken 21 des Greifers 20 in der Umgreifposition 31.

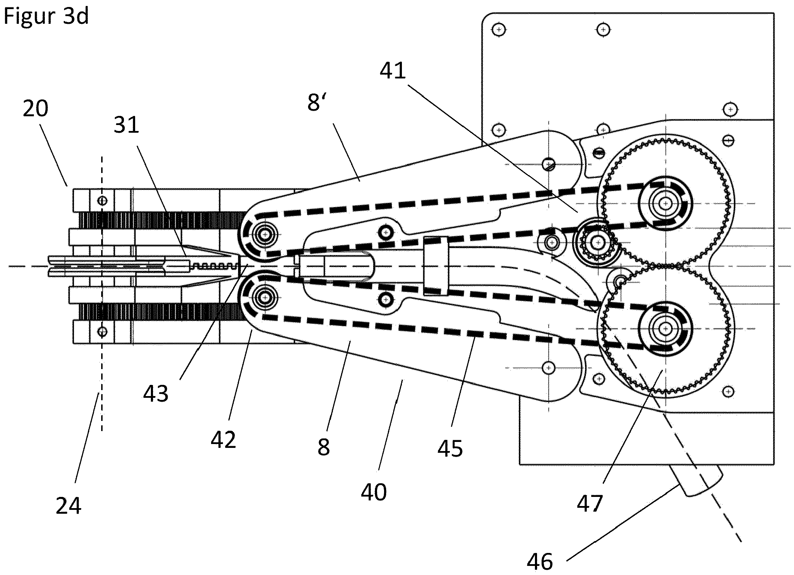

Figur 3d zeigt eine Draufsicht auf den Greifer 20 in der Umgreifposition 31 und die Drahtzuführeinrichtung 40. Die Litze (nicht dargestellt) wird dabei durch die Rollen 44 (Figur 3c) gefördert. Die Rollen 44 werden durch einen Riemen 45 mittels eines Zahnrades 47 und eines Antriebs 41 angetrieben. Die Kabellitze wird dabei über eine Zuführöffnung 46 in die Drahtzuführeinrichtung 40 eingeführt. Die Rollen 44 des Haltemechanismus 42 können mittels Antrieb 33 über die Wippen 8 und 8' geschlossen werden und somit eine Litze 10 (nicht dargestellt) halten bzw. in dieser geschlossenen Stellung in beide Richtungen fördern. Sind die Rollen 44 des Haltemechanismus 42 mit dem Antrieb 33 über die Wippen 8 und 8' geöffnet, kann ein Schwenken der beiden Greifbacken 21 von der Umgreifposition 31 zur Einsetzposition 30 mit eingesetzter Litze 10 erfolgen.

Figur 4a zeigt eine perspektivische Ansicht der Greiferbacken 21, 21'. Die Greiferbacken 21, 21' umschliessen die Litze 10. Die Litze 10 verläuft entlang einer Längsachse durch den Greifer 20, wobei der Litzenanfang 48 aus der Applikationsseite 22 herausragt. Das Litzenende 49 (Figur 4b) befindet sich noch in der Drahtzuführeinrichtung 40 (Figur 2a). Die Form des Greifers 20 wird durch eine Grundfläche D und einen Konuswinkel α definiert.

Figur 4b zeigt eine perspektivische Ansicht der Greiferbacken 21, 21'. Im Vergleich zu Figur 4a sind die Greiferbacken 21, 21' weiter voneinander entfernt und ermöglichen so, eine dickere Litze 10 zu umschliessen. Das Litzenende 49 der Litze 10 ragt aus der Applikationsseite 22 heraus. Die Litze 10 verläuft nicht wie in Figur 4a entlang einer Längsachse durch den Greifer 20, sondern wird seitlich durch eine Öffnung 32 aus dem Greifer 20 geführt, da der Litzenanfang 48 bereits angeschlossen wurde. Die Greiferbacken 21, 21' weisen Zähne 27 und Zahnlücken 28 auf, welche ineinander greifen.

Figur 4c zeigt einen Querschnitt durch eine Greiferbacke 21. Die Litze 10 liegt dabei in einem winkligen Profil 29. Das winklige Profil 29 kann wie dargestellt unterschiedlich dicke Litzen 10 umschliessen.

Figur 5 zeigt schematisch ein bevorzugtes System zum Planen von Verdrahtungen 6. Eine Montageplatte bzw. ein Montagerahmen 70 mit Bauteilen 71 und Kabelkanälen 73 liegt auf einem Tisch 72. Ein Verdrahtungsroboter 1 ist auf einem Roboterfuss 3 befestigt. Ein Roboterarm 2 umfasst einen Roboterkopf 4 an der zum Roboterfuss 3 gegenüberliegenden Seite. Der Roboterkopf 4 umfasst eine Messeinheit 50, eine Kamera 51 und einen Greifer 20. Der Verdrahtungsroboter 1 ist über eine Datenleitung 54 mit einer Rechnereinheit 52 und einer Eingabevorrichtung 53 verbunden. Der Ablauf des Planens der Verdrahtung erfolgt wie folgt:

Der Verdrahtungsroboter 1 erfasst systematisch die Position und Lage der Montageplatte/des Montagerahmens 70 und seiner Bauteile 71. Diese Daten werden in der Rechnereinheit 52 mit den geplanten Konstruktionsdaten, welche vorzugsweise aus einem CAD System generiert werden, abgeglichen. Anschliessend werden die korrigierten Verdrahtungsinformationen von der Rechnereinheit 52 zum Verdrahtungsroboter 1 geschickt, woraufhin der Verdrahtungsroboter die Bauteile 71 miteinander verdrahtet.

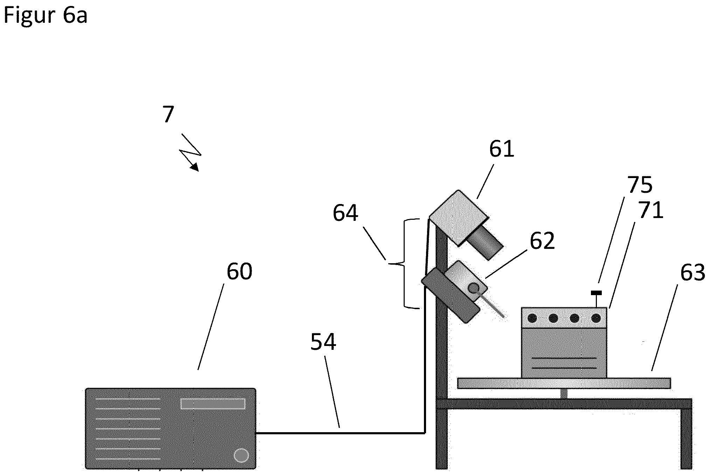

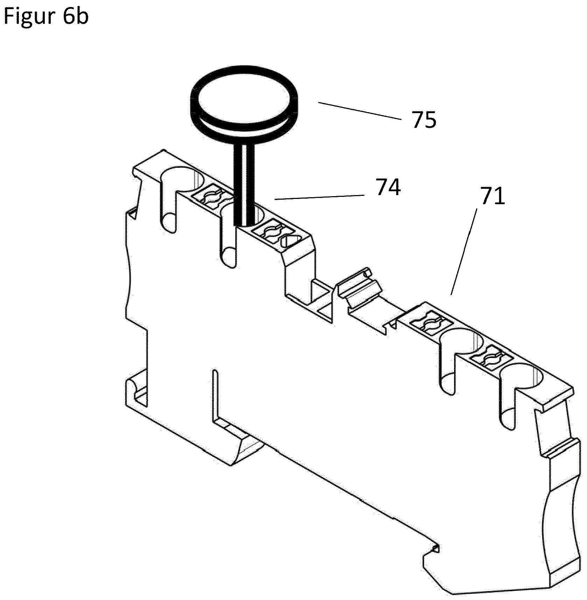

Figur 6a zeigt schematisch ein bevorzugtes System zum Erfassen von Bauteilen 7 insbesondere zum Erfassen von elektrischen Bauteilen. Das System umfasst einen Drehtisch 63. Ein elektrisches Bauteil 71 wird auf dem Drehtisch 63 platziert. Eine Erfassungseinheit 64 umfasst eine Kamera 61 und einen Laser 62, welche das elektrische Bauteil 71 erfassen. Die Erfassungseinheit leitet die Daten über eine Datenleitung 54 zu einer Rechneranordnung 60. Die Erfassungseinheit 64 erfasst die Form des Bauteils 71 und die Position eines von Hand eingeführten Messkörpers 75, welcher sich in einer Anschlussstelle 74 (Figur 6b) befindet. Zur Erfassung des Bauteils 71 wird mindestens eine volle Drehung des Drehtisches 63 vorgenommen.

Figur 6b zeigt eine perspektivische Ansicht des Bauteils 71 mit der Anschlussstelle 74 und dem Messkörper 75. Mittels des Messkörpers 75 werden die Position der Anschlussstelle 74 sowie die Tiefe und Richtung des Einschubkanals der Anschlussstelle vermessen.

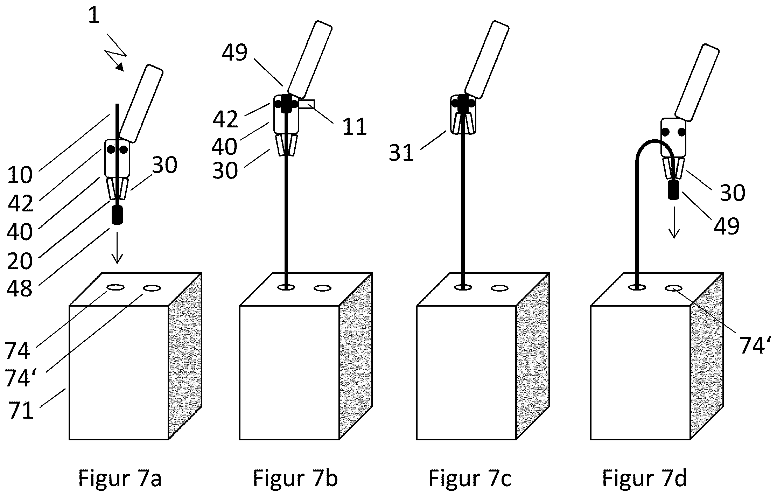

Figur 7a-d zeigt schematisch einen Verdrahtungsvorgang eines elektrischen Bauteils 71. Figur 7a zeigt ein elektrisches Bauteil 71 mit zwei Anschlussstellen 74, 74'. Ein Greifer 20 und eine Drahtzuführeinrichtung 40 bringen eine Litze 10 in Position, um einen Litzenanfang 48 in die Anschlussstelle 74 zu stecken. Nach erfolgtem Anschliessen kann wahlweise mittels einer Zugbewegung die Stabilität der Litze 10 in der Anschlussstelle 74 geprüft werden. Der Greifer 20 befindet sich in einer Einsetzposition 30 und ist geschlossen, während der Haltemechanismus 42 die Litze 10 klemmt. Nachdem der Litzenanfang 48 angeschlossen ist, verlegt der Verdrahtungsroboter 1 die Litze 10 gemäss einer geplanten Verdrahtung. Sobald ein Litzenende 49 in die Drahtzuführeinrichtung 40 eingezogen wird, klemmt der Haltemechanismus 42 das Litzenende 49 fest (Figur 7b). Das Litzenende 49 erzeugt einen Widerstand am Haltemechanismus 42, da es mit einer Endhülse mit Kragen ausgestattet ist, welche dicker ist die Litze 10 selbst. Alternativ kann das Litzenende 49 auch mit einem Fotosensor 11 erkannt werden, bevor es den Haltemechanismus 42 verlässt. Dies ist von Vorteil, wenn die Litze 10 keine Endhülse aufweist. Ergänzend kann die Litzenlänge der Litze 10 auch basierend auf der Umdrehung der Rollen 44 des Haltemechanismus 42 gemessen und überwacht werden. Sobald der Haltemechanismus 42 oder der Fotosensor 11 das Litzenende 49 erkennen, wird die Litze vorsorglich gestoppt. Der Greifer 20 kann gelöst werden (nicht dargestellt) und aus der Einsetzposition 30 in eine Umgreifposition 31 schwenken (Figur 7c). In der Umgreifposition 31 wird der Greifer 20 geschlossen und der Haltemechanismus 42 anschliessend geöffnet. Der Greifer 20 schwenkt zurück in die Einsetzposition 30 und kann nun das Litzenende 49 in die Anschlussstelle 74' einsetzen (Figur 7a).

## Patentansprüche

1. Verdrahtungsroboter (1), insbesondere zum Verdrahten von Montageplatten und Montagerahmen, von Schaltschränken und Schaltgerätekombinationen oder Teilen davon, umfassend einen Roboterkopf (4), eine Drahtzuführeinrichtung (40) für einen zu verlegenden Leiter (10), insbesondere eine Litze und einen Greifer (20) zum Halten und Applizieren der Litze (10),
wobei die Litze (10) mittels der Drahtzuführeinrichtung (40) dem Greifer (20) entlang eines Litzenpfads (43) zuführbar ist, **dadurch gekennzeichnet, dass**
der Greifer (20) bewegbar im Roboterkopf (4) montiert ist und der Greifer (20) mindestens zwischen einer Einsetzposition (30) und einer Umgreifposition (31) bewegbar ist, wobei ein Litzenende (49) der zugeführten Litze (10) in der Umgreifposition (31) mittels des Greifers (20) greifbar ist und der Litzenanfang (48) und/oder das Litzenende (49) der zugeführten Litze (10) in der Einsetzposition (30) mittels des Greifers (20) applizierbar ist und beim Applizieren ein Litzenanfang (48) oder ein Litzenende (49) in der Einsetzposition (30) des Greifers (20) aus einer Applikationsseite (22) des Greifers (20) herausragt.

2. Verdrahtungsroboter (1) gemäss Anspruch 1, **dadurch gekennzeichnet, dass** der Greifer (20) schwenkbar um eine Greiferschwenkachse (24) ausgebildet ist, insbesondere um eine Greiferschwenkachse (24), welche senkrecht zum Litzenpfad (43) steht.

3. Verdrahtungsroboter (1) gemäss einem der Ansprüche 1 oder 2, **dadurch gekennzeichnet, dass** in der Umgreifposition (31) die Applikationsseite (22) des Greifers (20) zur Drahtzuführeinrichtung (40) zeigt und in der Einsetzposition (30) die Applikationsseite (22) des Greifers (20) von der Drahtzuführeinrichtung (40) weg zeigt.

4. Verdrahtungsroboter (1) gemäss einem der Ansprüche 1 bis 3, **dadurch gekennzeichnet, dass** der Greifer (20) mindestens zwei Greifbacken (21) aufweist, welche insbesondere je ein winkliges Klemmprofil (29) aufweisen und wobei das winklige Klemmprofil (29) bevorzugt einen Winkel von 60 - 120°, besonders bevorzug einen Winkel von 70 - 110° und ganz besonders bevorzugt einen Winkel von 80 - 100° aufweist.

5. Verdrahtungsroboter (1) gemäss einem der Ansprüche 1 bis 4, **dadurch gekennzeichnet, dass** der Verdrahtungsroboter (1) einen Haltemechanismus (42) zum Fixieren einer Litze (10) aufweist, der mit einer Haltemechanismussteuerung gesteuert wird und eine Greifersteuerung, welche den Greifer (20) steuerbar macht.

6. Verdrahtungsroboter (1) gemäss Anspruch 5, **dadurch gekennzeichnet, dass** die Haltemechanismussteuerung so ausgebildet ist, dass die Litze (10) gehalten wird, während der Greifer (20) geöffnet ist und die Greifersteuerung so ausgebildet ist, dass der Greifer (20) geöffnet ist, während der Greifer (20) von der Einsetz- in die Umgreifposition (30,31) schwenkt.

7. Verdrahtungsroboter gemäss einem der Ansprüche 5 oder 6, **dadurch gekennzeichnet, dass** die Haltemechanismussteuerung so ausgebildet ist, dass die Litze (10) nicht gehalten wird, wenn der Greifer (20) in der Umgreifposition (31) geschlossen ist und dass die Greifersteuerung so ausgebildet ist, dass der Greifer (20) geschlossen ist, während der Greifer (20) von der Umgreif- in die Einsetzposition (31,30) schwenkt.

8. Verdrahtungsroboter (1) gemäss einem der Ansprüche 4 bis 7, **dadurch gekennzeichnet, dass** das Klemmprofil (29) der Greifbacke (21) des Greifers (20) eine Länge (L) von 5.0 - 20.0 mm, bevorzugt eine Länge (L) von 7.0 - 12.0 mm aufweist und/oder die Applikationsseite (22) eine Grundfläche (D) von weniger als 50 mm², bevorzugt weniger als 35 mm² und besonders bevorzugt von weniger als 25 mm² aufweist und der Greifer (20) eine Mantelfläche umfasst, welche sich in einen gedachten Konus befindet mit einem Konuswinkel (α) von 20°, bevorzugt 15° und besonders bevorzugt 10° gegenüber einer Längsachse.

9. Verdrahtungsroboter (1) zum Verdrahten von Montageplatten/Montagerahmen, insbesondere gemäss einem der Ansprüche 1 bis 8, umfassend einen Roboterkopf (4), eine Drahtzuführeinrichtung (40) für einen zu verlegenden Leiter, insbesondere eine Litze (10) und einen Greifer (20) zum Halten und Applizieren einer Litze (10), **dadurch gekennzeichnet, dass** die Litze (10) insbesondere durch eine Applikationsseite (22) hindurch, mit dem Greifer (20) aufnehmbar und mit einer Drahtzuführeinrichtung (40) einziehbar ist.

10. Verdrahtungsroboter (1) zum Verdrahten von Montageplatten und Montagerahmen, insbesondere gemäss einem der Ansprüche 1 bis 9, umfassend einen Roboterkopf (4), eine Drahtzuführeinrichtung (40) für einen zu verlegenden Leiter, insbesondere eine Litze (10) und einen Greifer (20) zum Halten und Applizieren der Litze (10), **dadurch gekennzeichnet, dass** der Verdrahtungsroboter (1) ein kollaborativer Roboter ist.

11. System zum Planen von Verdrahtungen (6), insbesondere zum Verdrahten von Montageplatten und Montagerahmen, von Schaltschränken und Schaltgerätekombinationen oder Teilen davon umfassend:
eine Messeinheit (50) zum Erfassen der Art und Position von elektrischen Komponenten und Bauteilen (71), insbesondere auf einer Montageplatte und/oder einem Montagerahmen eines Schaltschrankes oder einer Schaltgerätekombination oder eines Teils davon,
eine Rechneranordnung (52) zur Verarbeitung der Messresultate und
eine Eingabevorrichtung (53) zur Eingabe von Verdrahtungsinformationen, **dadurch gekennzeichnet, dass** die Rechneranordnung (52) dazu ausgebildet ist, auf Basis der Verdrahtungsinformation und der mit der Messeinheit (50) ermittelten Art und Position der Komponenten und Bauteilen (71) gegeben falls die Position der Komponenten und Bauteile (71) zu korrigieren.

12. System zum Erfassen von Bauteilen (7), insbesondere zum Erfassen von elektrischen Bauteilen (71) umfassend:
eine Speicheranordnung (60) zur Speicherung von Informationen über ein elektrisches Bauteil (71),
und eine Erfassungseinheit (64) zum Erfassen der Form und
Ausmasse des elektrischen Bauteils (71), **dadurch gekennzeichnet, dass** mit der Erfassungseinheit (64) ein in eine Anschlussstelle (74) eingesetzter Messkörper (75) erfassbar ist, wobei der Messkörper (75) die Anschlussstelle (74) charakterisiert, insbesondere eine Position, eine Richtung und eine Einschubtiefe mittels der Speicheranordnung bestimmbar macht.

13. Verfahren zum Verdrahten von Montageplatten und Montagerahmen, von Schaltschränken und Schaltgerätekombinationen oder Teilen davon, unter Verwendung eines Verdrahtungsroboters (1) mit einem Greifer (20) und einer Drahtzuführeinrichtung (40), insbesondere nach einem der Ansprüche 1 bis 8, umfassend die folgenden Schritte:
- Einsetzen eines Anfangs einer Litze (10) in einer ersten Anschlussstelle (74) eines ersten elektrischen Bauteils (71) ;
- Führen der Litze (10) gemäss eines geplanten Drahtverlaufs zu einer zweiten Anschlussstelle (74'), insbesondere in einem zweiten Bauteil (71');
- Klemmen der Litze (10) mit einem Haltemechanismus (42);
- Öffnen des Greifers (20);
- Umschwenken des Greifers (20) in eine Umgreifposition (31), so dass eine Applikationsseite (22) des Greifers (20) zu einem Litzenende (49) zeigt;
- Schliessen des Greifers (20) und anschliessend Öffnen des Haltemechanismus (42);
- Wenden des Greifers (20) von der Umgreifposition (31) in die Einsetzposition (30);
- Einsetzen des Litzenendes (49) in die zweite Anschlussstelle (74').

14. Verfahren zum Verdrahten von Montageplatten und Montagerahmen, von Schaltschränken und Schaltgerätekombinationen oder Teilen davon unter Verwendung eines kollaborativen Verdrahtungsroboters (1), insbesondere nach einem Verdrahtungsroboters (1) gemäss Anspruch 10.

15. Verfahren zum Verdrahten von Montageplatten und Montagerahmen, von Schaltschränken und Schaltgerätekombinationen oder Teilen davon, unter Verwendung eines Verdrahtungsroboters (1), insbesondere eines Verdrahtungsroboters (1) gemäss einem der Ansprüche 1 bis 8, **dadurch gekennzeichnet, dass** der Verdrahtungsroboter (1) eine ausserhalb einer Drahtzuführeinrichtung (40) liegende Litze (10) mit einem Greifer (20) aufnimmt und mittels der Drahtzuführeinrichtung (40) einzieht, bis nur noch ein Litzenanfang (48) einer Litze (10) mit einer Anschlussseite aus einer Applikationsseite (22) des Greifers (20) herausragt.

16. Verfahren zum Verdrahten von Montageplatten und Montagerahmen, von Schaltschränken und Schaltgerätekombinationen oder Teilen davon, insbesondere unter der Verwendung eines Verdrahtungsroboters (1) gemäss einem der Ansprüchen 1 bis 8 und eines Systems zum Planen von Verdrahtungen (6) gemäss Anspruch 11, umfassend die Schritte:
- Erfassen von elektrischen Bauteilen (71) auf einer Montageplatte oder Montagerahmen eines Schaltschrankes oder einer Schaltgerätekombination oder eines Teils davon (70)
- Schicken der Verdrahtungsanweisungen vom System zum Planen von Verdrahtungen(6) zum Verdrahtungsroboter (1)
- Verdrahten der Montageplatten und Montagerahmen, von Schaltschränken und Schaltgerätekombinationen oder Teilen davon (70) durch den Verdrahtungsroboter (1).

17. Verfahren zum Vermessen eines elektrischen Bauteils (71) zur Planung einer Verdrahtung, insbesondere zur Verdrahtung einer Montageplatte oder eines Montagerahmens eines Schaltschrankes oder einer Schaltgerätekombination oder eines Teils davon (70), umfassend die Schritte:
- Einsetzen eines Messkörpers (75) in das Bauteil (71), wobei der Messkörper (75) eine Anschlussstelle (74) zur Verdrahtung und dessen Einschubtiefe (T) in das elektrische Bauteil (71) markiert
- Scannen des elektrischen Bauteils (71) und des eingesetzten Messkörpers (75)
- Bestimmung der Anschlussstelle (74) und Einschubtiefe (T) des elektrischen Bauteiles (71) mit Hilfe einer Rechneranordnung (52), zur Positionsbestimmung des Messkörpers (75)
- Speichern von charakteristischen geometrischen Werten des elektrischen Bauteiles (71), sowie der Position und Einschubtiefe (T) der Anschlussstelle (74) zur Verdrahtung.
